Europäisches Patentamt

European Patent Office

Office européen des brevets

(11) Veröffentlichungsnummer: **0 084 876**
A2

(19)

(12) **EUROPÄISCHE PATENTANMELDUNG**

(21) Anmeldenummer: 83100559.0

(22) Anmeldetag: 22.01.83

(51) Int. Cl.³: **H 03 D 3/00,** H 03 J 7/02,
H 03 G 3/20

(30) Priorität: 25.01.82 US 342442

(43) Veröffentlichungstag der Anmeldung: 03.08.83
Patentblatt 83/31

(84) Benannte Vertragsstaaten: **BE DE FR GB NL**

(71) Anmelder: **International Standard Electric Corporation,
320 Park Avenue, New York New York 10022 (US)**

(72) Erfinder: **Reed, Joseph, 667 Westover Road, Stamford
Connecticut (US)**

(74) Vertreter: **Pohl, Heribert, Dipl.-Ing et al, Standard
Elektrik Lorenz AG Patent- und Lizenzwesen Kurze
Strasse 8 Postfach 300 929, D-7000 Stuttgart 30 (DE)**

(54) Demodulatoranordnung zur Demodulation von in Frequenzmodulation auf einer Trägerfrequenzwelle enthaltener Signale.

(57) Eine Demodulatorschaltung zur Demodulation frequenzmodulierter Trägerwellen zur Anwendung in einer Null-ZF-Anordnung verwendet einen lokalen Oszillator zur Erzeugung in der Phase quadrierter Ausgangssignale mit einer Frequenz, die gleich der Trägerfrequenz der zu demodulierenden Welle ist. Eine erste und eine zweite Mischschaltung zur getrennten Mischung des frequenzmodulierten Signales mit den Ausgangssignalen des lokalen Oszillators erzeugen ein erstes und ein zweites Ausgangssignal in Phasenquadratur zueinander. Zwei weitere Mischschaltungen mischen das Ausgangssignal eines spannungsgesteuerten Oszillators ebenfalls mit den Phasenquadratursignalen des lokalen Oszillators. Die Ausgänge der beiden ersten Mischerschaltungspaare sind über Tiefpassfilter mit den Mischeingängen eines dritten Mischschaltungspaares verbunden, dessen Ausgänge an die Eingänge eines Differenzverstärkers angeschlossen sind. Das Ausgangssignal des Differenzverstärkers regelt die Frequenz des spannungsgesteuerten Oszillators derart, dass das Ausgangssignal des Differenzverstärkers gleichzeitig die demodulierte Spannung ist.

- 1 -

J. Reed-3

Demodulatoranordnung zur Demodulation
von in Frequenzmodulation auf einer
Trägerfrequenzwelle enthaltener Signale

Die Erfindung betrifft eine Demodulatoranordnung zur Demodulation von in Frequenzmodulation auf einer Trägerfrequenzwelle enthaltener Signale der im Oberbegriff des Anspruches 1 angegebenen Art.

In den letzten Jahren führt ein Bestreben immer mehr dahin,
den Aufwand an abstimmbaren Kreisen in Rundfunkempfängern
zu reduzieren, um große Teile der Empfängerschaltungen in
integrierten Schaltkreisen unterzubringen. Dadurch können
sehr kompakte Empfangsgeräte hergestellt werden.

Einen wesentlichen Durchbruch für die Herstellung derartiger
Empfänger brachte die sogenannte Null-ZF-Technik, wie sie
beispielsweise in der am 01. November 1978 veröffentlichten
GB-PS 1 530 602 beschrieben ist. Darin ist ein Empfangsgerät mit einem lokalen Oszillator offenbart, dessen beide
Ausgangssignale zueinander in Phasenquadratur liegen und
die Frequenz der Trägerfrequenzwelle aufweisen und die jede
für sich getrennt mit der ankommenden, das Tonsignal enthaltenden Trägerfrequenz gemischt werden. Das Ausgangssignal der beiden Mischschaltungen enthält auf einen Null-ZF-
Träger zwei übereinander gefaltete Seitenbänder, die sich

ZT/P2-Lr/fö
18.01.1983

J.Reed-3

von 0 bis zur Bandbreite des Einseitenbandes des auf dem ankommenden Träger modulierten Signals erstrecken.

Im Falle der Frequenzmodulation macht es die Faltung der Seitenbänder nahezu unmöglich, das Nutzsignal zu demodulieren. Beim Gegenstand des britischen Patents gelangen die Ausgangssignale der Mischschaltungen über Tiefpaßfilter zu Verstärkern, in denen sie auf einen vorgegebenen Wert verstärkt werden. Die Ausgangssignale der Verstärker werden anschließend differenziert. Das Ausgangssignal jeweils der einen Differenzierschaltung wird mit dem Eingangssignal jeweils der anderen Differenzierschaltung multipliziert und von den Ausgangssignalen der beiden Multiplizierschaltungen die Differenz gebildet. Ein derartiges Verfahren ist auch aus der US-PS 4 238 850 bekannt.

In diesen bekannten Demodulatoranordnungen werden beispielsweise phased-locked-loop-Demodulatoren verwendet, die auf die Frequenz der Trägerfrequenzwelle abgestimmt sind. Der lokale Oszillator einer derartigen Anordnung folgt dem Nutzsignal und die Abstimmspannung für einen derartigen lokalen Oszillator verläuft deshalb proportional der Spannungskurve des Nutzsignals einschließlich einer Konstanten. Wird diese Abstimmspannung ohne der Konstanten ausgekoppelt, so ist das ausgekoppelte Signal ein Abbild der Hüllkurve des Nutzsignals und stellt deshalb die Modulation dar.

Ein Nachteil der bekannten Demodulatoranordnungen ist der, daß die Phasenrastschleifen wegen der Stabilität ihrer Eigenschaften steile Filter im Trägerkanal verhindern. Demgemäß ist die nachfolgende Kanaltrennung relativ gering und ein derartiger Empfänger ist sehr schwer zu verwirklichen. Unter Berücksichtigung dieser Nachteile verwenden

J. Reed-3

andere bekannte Anordnungen zwei Kanäle in Phasenquadratur. Dadurch können steile Filter verwendet werden und die ausgefilterten Signale können demoduliert werden. Gegenwärtig wird der eine Kanal in Phase und der andere in Quadratur betrieben und dieses Verfahren I+Q-Verfahren genannt. Wie bereits erwähnt arbeitet dieses Verfahren mit der Trägerfrequenzwelle. Es können damit doppelseitenband-, einseitenband--amplitudenmodulierte Signale als auch frequenzumgetastete Signale demoduliert werden.

Augenblicklich werden in Empfangsgeräten, die nach dem I+Q-Verfahren arbeiten, passive Bauelemente zur Übertragung der Trägerfrequenzwelle benutzt, so daß sie demoduliert werden können. Bei der Verwendung von passiven Bauelementen können jedoch keine Rückkopplungsmittel zur Stabilisierung des Empfängers verwendet werden. In einem derartigen I+Q-Verfahren wird jedes Trägerfrequenzwellensignal differenziert, anschließend mit dem undifferenzierten anderen Signal multipliziert und dann summiert. Der andere Kanal, entweder der I- oder der Q-Kanal wird in ähnlicher Weise behandelt. Infolge von Ungleichheiten und Unvollkommenheiten der Schaltkreistechniken entstehen bei diesem Verfahren Störgeräusche und Verzerrungen. Phasenabweichungen im Phase-Kanal und im Quadratur-Kanal erzeugen ebenfalls Geräuschstörungen und Verzerrungen. Bei Abstimmungsfehlern werden Schwebungstöne erzeugt, die weitere Störungen im Übertragungsablauf hervorrufen.

Hinzu kommen Störungen durch Bauelemente mit unsymmetrischen Eigenschaften, wie z.B. Multiplizierer und andere Schaltungen, die sich den oben angegebenen Geräuschstörungen und Verzerrungen überlagern. Weiterhin erfordert ein derartiges Verfahren eine enge automatische Verstär-

0084876

J. Reed-3

kungsregelung zum Ausgleich unterschiedlicher Amplituden der Ausgangssignale oder zusätzliche aufwendige Schaltungen zur Beseitigung der Störungen.

Auch eine Digitaltechnik zur Übertragung und anschließender Demodulation der Trägerfrequenzwellensignale verhindert nicht die angegebenen Nachteile. Sie führt nur noch zu weiteren Problemen, die beispielsweise von den notwendigen hohen Pegeln der Digitalsignale herrühren.

Der Erfindung liegt deshalb die Aufgabe zugrunde, eine Demodulatoranordnung der eingangs angegebenen Art anzugeben, die mit zwei Kanälen arbeitet, aber die Nachteile des I+Q-Verfahrens vermeidet. Diese Aufgabe wird nach der Erfindung durch die im kennzeichnenden Teil des Anspruches 1 angegebenen technischen Merkmale gelöst.

Durch die Phasenaufteilung des lokalen Oszillators werden bei einer erfindungsgemäßen Demodulatoranordnung die störenden Auswirkungen kleiner Phasenungenauigkeiten verhindern. Die automatische Frequenzregelung verhindert störende Frequenzabweichungen der Demodulatoranordnung. Ausserdem kann in der erfindungsgemäßen Demodulatoranordnung eine selbsttätige Verstärkugnsregelung vorgesehen werden, die eine größere Dynamikbandbreite der Anordnung erlaubt. Durch diese Maßnahme sind für die Trägerfrequenzwelle keine Verstärker mit einer hohen Verstärkung erforderlich. Vielmehr können in diesem Fall Verstärker mit einer fest eingestellten Verstärkung oder Verstärker mit einer geringen regelbaren Verstärkung verwendet werden. Dadurch können bei diesen Verstärkern große Rückkopplungsfaktoren angewendet werden, so daß die Gleichheit der Eigenschaften und der Verstärkung auf den beiden Kanälen verbessert werden kann.

0084876

— 5 —

J. Reed-3

Eine erfindungsgemäße Demodulatoranordnung ist zwar ihrer Natur nach eine Analogschaltung. Sie ist jedoch in vorteilhafter Weise so ausgebildet, daß sie leicht als integrierte Schaltung hergestellt werden kann.

Die Erfindung wird nachfolgend anhand eines vorteilhaften Ausführungsbeispieles näher erläutert. In der zugehörigen Zeichnung zeigen

Figur 1 ein Blockschaltbild einer Demodulatoranordnung zur Demodulation von in Frequenzmodulation auf einer Trägerfrequenzwelle enthaltener Signale,

Figur 2 ein vereinfachtes Blockschaltbild einer Schaltungsanordnung zur Bildung eines Regelsignales zur selbsttätigen Regelung der in der Schaltungsanordnung gemäß Figur 1 enthaltenen Verstärker.

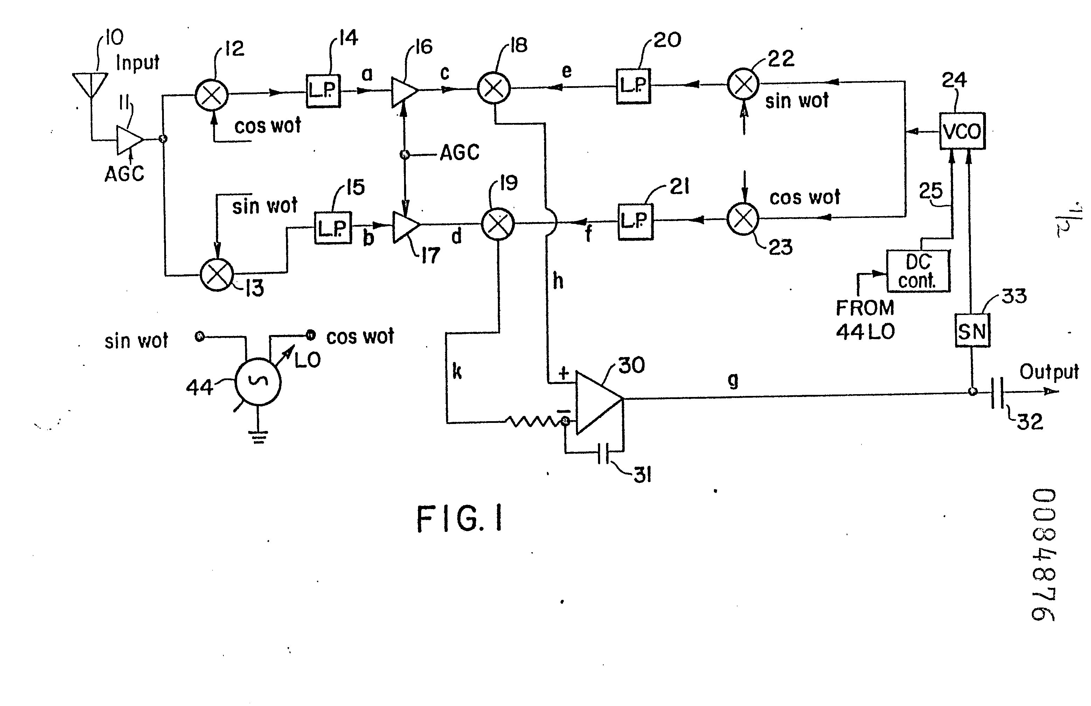

In Figur 1 ist ein schematisches Blockschaltbild eines Empfängers mit einer Demodulatoranordnung zur Demodulation von in Frequenzmodulation auf einer Trägerfrequenzwelle enthaltenen Signale gezeigt. An einer Antenne 10 wird eine Trägerfrequenzwelle, auf die in Frequenzmodulation ein Nutzsignal aufmoduliert ist, empfangen und an den Eingang eines Regelverstärkers 11 übertragen. Der Regelverstärker 11 erhält an seinem Regeleingang ein mit AGC bezeichnetes Verstärkungsregelungssignal, das in einer weiter unten beschriebenen Schaltung erzeugt wird. An den Ausgang des Verstärkers 11 ist der eine Eingang einer ersten Mischschaltung 12 und der eine Eingang einer zweiten Mischschaltung 13 angeschlossen. An ihrem anderen Eingang erhalten beide Mischschaltungen 12 und 13 ein Ausgangssignal eines loka-

J. Reed-3

len Oszillators 44. Der lokale Oszillator 44, der bei- spielsweise in der Gestalt eines Frequenz-Synthesizers oder in einer anderen abstimmbaren Schaltung ausgebildet sein kann, enthält eine Quadraturschaltung, die aus der Oszillatorfrequenz ein erstes Signal der Gestalt $\sin w_0 t$ und ein zweites Ausgangssignal der Gestalt $\cos w_0 t$ er- zeugt. Wie in Figur 1 dargestellt ist erhält die Mischerschaltung 12 das Oszillatorsignal $\cos w_0 t$ und die Mischer- schaltung 13 das Oszillatorsignal $\sin w_0 t$.

An den Ausgang der Mischerschaltung 12 ist ein Tiefpaßfil- ter 14 angeschlossen und an den Ausgang der Mischerschal- tung 13 ein Tiefpaßfilter 15. Die Bandbreite der beiden Tiefpaßfilter 14 und 15 ist so ausgelegt, daß sie wenigstens so breit ist wie die angenommene größte Abweichung der Frequenz der Trägerwelle von der Frequenz des lokalen Oszillators 44. Auf diese Weise entstehen am Ausgang der beiden Tiefpaßfilter 14 und 15 offensichtlich zwei Signale, die durch die Quadratur um $90^o$ gegeneinander gedreht sind. Wesentlich ist, daß die am lokalen Oszillator 44 einge- stellte Frequenz zur Erzeugung der beiden in Phasenquadra- tur befindlichen Ausgangssignale des Oszillators gleich der Frequenz der Trägerwelle für das frequenzmodulierte Nutz- signal ist. Diese Einstellung ist vom Null-ZF-Verfahren bekannt.

Der Ausgang a des Tiefpaßfilters 14 ist an den Eingang eines Verstärkers 16 angeschlossen und der Ausgang b des Tiefpaßfilters 15 ist an den Eingang eines Verstärkers 17 angeschlossen. Die Verstärker 16 und 17 weisen beispielsweise ebenfalls eine regelbare Verstärkung auf, die bei- spielsweise durch das gleiche Regelsignal AGC an ihren Regeleingängen regelbar ist, wie der Regelverstärker 11. Der Ausgang c des Verstärkers 16 ist an einen Eingang

J. Reed-3

einer multiplikativen Mischschaltung 18 angeschlossen während der Ausgang d des Verstärkers 17 an einen Eingang einer multiplikativen Mischschaltung 19 angeschlossen ist. Der andere Eingang der Mischschaltung 18 wird vom Ausgang e eines Tiefpaßfilters 20 gespeist, während der andere Eingang der Mischschaltung 19 vom Ausgang f eines Tiefpaßfilters 21 gespeist wird. Der Eingang des Tiefpaßfilters 20 ist an dem Ausgang einer Mischschaltung 22 angeschlossen während der Eingang des Tiefpaßfilters 21 an den Ausgang einer Mischschaltung 23 angeschlossen ist. Die Mischschaltung 22 empfängt an ihrem einen Eingang das Signal sin $w_0t$ des Lokalen Oszillators 44, während die Mischschaltung 23 an ihrem einen Eingang das Signal cos $w_0t$ des lokalen Oszillators 44 empfängt. Die anderen Eingänge der Mischerschaltungen 22 und 23 werden von einem spannungsgesteuerten Oszillator 24 gespeist, dessen Frequenz eingestellt werden kann. Der spannungsgesteuerte Oszillator 24 weist einen Abstimmeingang 25 auf, an dem er eine vom lokalen Oszillator 44 erzeugte Abstimmgleichspannung erhält zur Einstellung einer gewünschten Frequenz.

Wie aus der Figur 1 ersichtlich ist, weist die Demodulatoranordnung zwei Kanäle mit je drei Mischschaltungen auf, einen oberen Kanal mit den Mischschaltungen 12, 18 und 22 und einen unteren Kanal mit den drei Mischschaltungen 13, 19 und 23. Der Ausgang h der Mischschaltung 18 ist an den nichtinvertierenden Eingang eines Operationsverstärkers 30 angeschlossen, während der Ausgang k der Mischschaltung 19 über einen Widerstand an den mit Minus bezeichneten invertierenden Eingang des Operationsverstärkers 30 angeschlossen ist. Der Operationsverstärker 30 ist als Integrator ausgebildet und hat deshalb zwischen seinem Ausgang g und seinem invertierenden Eingang einen Kondensator 31 angeordnet.

J. Reed-3

Das über einen Kondensator 32 vom Ausgang g des Operationsverstärkers ausgekoppelte Wechselstromsignal entspricht der Modulation des an der Antenne 10 empfangenen Eingangssignales.

Das Ausgangssignal des Operationsverstärkers 30 regelt über ein Stabilisationsnetzwerk 33 die Frequenz des spannungsgesteuerten Oszillators 24 und stellt damit sicher, daß Störungen, die den bekannten Verfahren innewohnen verhindert werden. Die Frequenzregelung des spannungsgesteuerten Oszillators 24 bewirkt dadurch, daß das Ausgangssignal der Demodulatoranordnung stets proportional zur Modulation ist und daß durch Ungleichheiten zwischen den zwei Kanälen hervorgerufene Fehler unterdrückt oder wesentlich reduziert werden.

Die Funktion der beschriebenen Anordnung wird am einfachsten an Hand von mathematischen Beziehungen erläutert, die die Funktion steuern. Die veränderlichen Signale werden in diesen Gleichungen mit kleinen Buchstaben bezeichnet, während für die Konstanten der Gleichung große Buchstaben vorgesehen werden. Für den Funktionsablauf wird angenommen, daß das an den Eingang der Mischerschaltungen 12 und 13 angelegte Signal, das an der Antenne 10 empfangen und in dem Verstärker 11 verstärkt wurde, durch folgenden Ausdruck dargestellt werden kann:

$$A' \sin (w_c t + \delta)$$

worin $w_c$ die Trägerfrequenz ist, $\delta$ eine das frequenzmodulierte Nutzsignal darstellende zeitabhängige Funktion ist und A' eine Amplitude ist.

Am Ausgang a des Tiefpasses 14 tritt folgendes Signal auf:

$$A'' \sin [(w_c - w_0) t + \delta]$$

J. Reed-3

und nach der Verstärkung im Verstärker 16 an dessen Ausgang c:

$$\text{(I)} \quad A \sin \left[ (w_c - w_o) \, t + \delta \right]$$

Am Ausgang d des Verstärkers 17 entsteht auf entsprechende Weise das Signal:

$$\text{(II)} \quad A^o \cos \left[ (w_c - w_o) \, t + \delta \right]$$

Im Null-ZF-Verfahren wird die Frequenz $w_o$ des lokalen Oszillators 44 so eingestellt, daß sie normalerweise gleich der Trägerfrequenz $w_c$ ist. Dadurch reduzieren sich die Ausdrücke (I) und (II) auf:

$$\text{(I')} \quad A \sin \delta$$
$$\text{(II')} \quad A^o \cos \delta$$

worin $A$ und $A^o$ etwa gleichgroß sind.

Zwischen den beiden Frequenzen $w_o$ und $w_c$ wird ein kleiner Einstellfehler $\Omega_1 = (w_c - w_o)$ angenommen.

Durch die Schaltung zur Erzeugung der Abstimmspannung für den spannungsgesteuerten Oszillator 24 wird über den Eingang 25 eine Abstimmspannung an den Oszillator 24 angelegt, die den spannungsgesteuerten Oszillator 24 auf eine Frequenz $w_a$ einstellt, die von der Einstellung des lokalen Oszillators 44 bestimmt ist und die dicht bei der Abstimmfrequenz $w_o$ des lokalen Oszillators liegt, aber nicht notwendigerweise dieser gleich ist. Dann ist das Ausgangssignal des spannungsgesteuerten Oszillators 24 durch folgenden Ausdruck bezeichnet:

$$D' \sin (w_a \, t + \beta)$$

worin $\beta$ eine willkürliche Phase in der Gestalt einer zeitabhängigen Funktion ist und

$D'$ eine Amplitude

J. Reed-3

Das Signal am Ausgang e des Tiefpasses 20 ist dann:

(III) $D \cos [(w_a - w_o) t + \beta] = D \cos(\Omega_2 t + \beta)$

und am Ausgang f des Tiefpasses 21:

(IV) $D \sin [(w_a - w_o) t + \beta] = D \sin(\Omega_2 t + \beta)$

worin $\Omega_2$ der Einstellfehler für die Einstellung der Frequenz $w_a$ ist.

Die Signale an den Ausgängen c und e gelangen an die Eingänge der Mischschaltung 18. Arbeitet diese beispielsweise als multiplikativer Mischer, entsteht an seinem Ausgang h folgendes Signal:

(V) = (I') x (III) = $AD \sin (\Omega_1 t + \delta) \times \cos(\Omega_2 t + \beta)$

Entsprechend entsteht am Ausgang k der Mischerschaltung 19 das Signal:

(VI) = (II') X (IV) = $AD \cos (\Omega_1 t + \delta) \times \sin(\Omega_2 t + \beta)$

Diese beiden Signale (V) und (VI) werden im Operationsverstärker 30 subtrahiert:

(VII) = (V) - (VI)

$= AD \{ \sin [(\Omega_1 - \Omega_2) t + (\delta - \beta)] \ldots\ldots.$

Da dieses Signal (VII) ein Fehlersignal in einem Rückkopplungskreis darstellt wird es gegen Null getrieben. Das kann nur geschehen, wenn

$(\Omega_1 - \Omega_2) t + (\delta - \beta) \to 0$

Diese Bedingung wird erfüllt, wenn

(VIII) $\Omega_1 = \Omega_2$, d.h. $w_a = w_c$

$\delta = \beta$

Das Ergebnis $w_a = w_c$ stellt eine selbsttätige automatische Frequenzregelung dar. Da $\beta$ proportional zur Ausgangsspannung am Ausgang g des Operationsverstärkers 30 ist und

J. Reed-3

nach der Gleichung $\delta = \beta$ gleich der der Trägerwelle aufmodulierten Nutzspannung ist, ist die Ausgangsspannung der Demodulatoranordnung proportional der Nutzspannung. Auf diese Weise stellt das Ausgangssignal am Kondensator 35 die Modulation auf der Trägerwelle dar.

Wird der Kondensator 31 am Operationsverstärker 30 in Figur 4 durch einen Widerstand ersetzt, integriert der Operationsverstärker 30 das Fehlersignal $\delta - \beta$ nicht mehr und $\beta$ ist dann nicht mehr genau das Abbild des Signals $\delta$. Weist der Operationsverstärker jedoch eine hohe Verstärkung auf, wird dieser Fehler vernachlässigbar. Arbeitet der Operationsverstärker 30 aber als Integrator und kann an seinem Ausgang eine Spannung bestehen, auch wenn die Eingangsspannung Null ist, kann die Abweichung theoretisch auf Null getrieben werden.

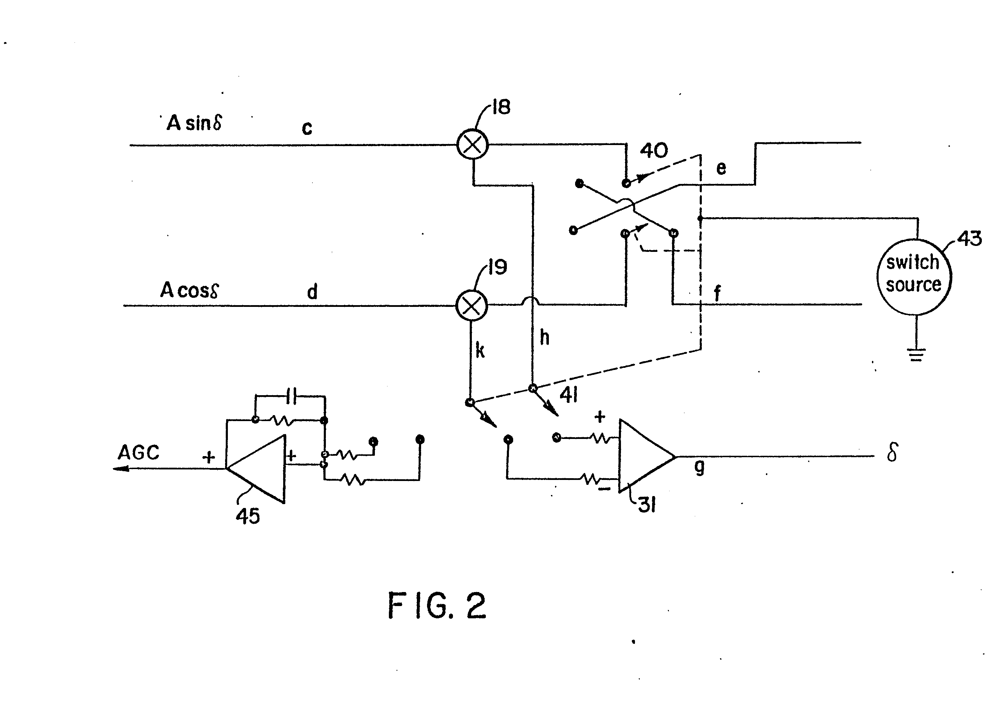

In Figur 2 ist eine Schaltungsanordnung zur Erzeugung eines Regelsignales AGC zur Regelung der Verstärkung des Vorverstärkers 11 und der Verstärker 16 und 17. Darin aus Figur 1 übernommene Schaltungselemente weisen die gleichen Bezugszeichen auf wie in Figur 1.

Wie zuvor bezüglich der automatischen Frequenzregelung erläutert, ist man bemüht, die Frequenz $w_o$ des lokalen Oszillators gleich der Trägerfrequenz $w_c$ zu halten. Deshalb ist das Eingangssignal der Mischerschaltung 18 vom Ausgang c: A sinδ und das vom Ausgang b kommende Eingangssignal für die Mischerschaltung 11: A x cosδ.

Die anderen Eingangssignale für die Mischerschaltungen 18 und 19 von den Ausgängen e und f der Tiefpaßfilter 20 und 21 werden über einen ersten zweipoligen elektronischen Umschalter 40 an die Eingänge der Mischerschaltungen 18

J. Reed-3

und 19 gelegt. Der Schalter 40 kann eine FET- oder eine MOS-Schaltung sein, deren Steuerelektroden von einer Quelle 43 mit einem hochfrequenten Schaltsignal gesteuert werden. Im vorliegenden Fall ist die Schaltfrequenz des Schaltsignals wenigstens zwei mal so hoch als die höchste Durchgangsfrequenz des FM-Eingangssignales, entsprechend der Nyquist-Theorie. In ähnlicher Weise werden die Ausgänge k und h der Mischerschaltungen 18 und 19 an die Umschaltanschlüsse eines zweipoligen elektronischen Umschalters 41 gelegt. Dieser Umschalter 41 schaltet die Ausgänge abwechselnd an die Eingänge des Operationsverstärkers 30 und die Eingänge eines zweiten Verstärkers 45. Der Ausgang des Operationsverstärkers 30 erzeugt weiterhin zum Signal δ proportionale Signale und damit ein das Modulationssignal darstellendes Signal. Am Ausgang des Verstärkers 45 entsteht ein Gleichstromsignal, das proportional der Amplitude der verwendeten Wellenformen in der Anordnung ist und daß direkt als Regelsignal AGC für die Verstärkungsregelung verwendet wird.

Wie aus Figur 2 entnehmbar ist wird das Verstärkungsregelungssignal AGC folgendermaßen verwirklicht: Werden die Phasen des Frequenzsatzes $(\Omega_2)$ von den Mischschaltungen 22 und 23 nicht invertiert bezüglich des Frequenzsatzes $(\Omega_1)$ der Mischerschaltungen 12 und 13, erhält man:

1. $AD \times \sin(\Omega_1 \times t + \delta) \times \sin(\Omega_2 \times t + \beta)$
2. $A \times D \times \cos(\Omega_1 \times t + \delta) \times \cos(\Omega_2 \times t + \beta)$

Die Subtraktion von 1. und 2. ergibt:

$$A \times D \left[- \cos(\Omega_1 \times t + \delta) + (\Omega_2 \times t + \beta)\right]$$

Dies ergibt kein nützliches Ausgangssignal. Wird alternativ hierzu die Phase nicht invertiert, die sich dann ergebenden Ausgangssignale 1. und 2. summiert unter der Be-

J. Reed-3

dingung, daß $\Omega_1 = \Omega_2$ und $\delta = \beta$ ist, erhält man

$$1. + 2. = A \times D \times \sin^2\delta \times \cos^2\delta = A \times D$$

Dieser Ausdruck für eine Gleichspannung stellt eine Regel-spannung AGC für die Verstärkungsregelung dar. Dieser Aus-druck kann schaltungsmäßig verwirktlich werden durch Umschalten der Ansteuerung der beiden Mischschaltungen mit einer Schaltrate, die weit genug jenseits der Durchlaß-frequenzen der Filter der in Figur 1 dargestellten Anord-nung ist.

Im folgenden soll dargestellt werden, in welcher Weise sich die in Figur 1 dargestellte Schaltungsanordnung sich vorteilhaft gegenüber den meisten typischen Störungen unterscheidet, die in bekannten Anordnungen auftreten. Dies soll wieder anhand mathematischer Ausdrücke beschrieben werden.

Zunächst sei angenommen, daß die Signale mit der Frequenz $w_o$ nicht genau genug in die beiden in der Phase um 90° versetzten Signale aufgeteilt werden können. Das bedeutet einen unvermeidbaren Fehler in der Phasenaufteilung. Wir nehmen anstelle der Ausgangssignale $\sin w_o t$ und $\cos w_o t$ die tatsächlichen Signale

$$\sin w_o t \quad \text{und} \quad \cos (w_o t - \phi)$$

wobei $\phi = 0$ bis 90°. Dann treten am Ausgang der Mischschaltungen 18 und 19 folgende Signale auf:

$$\sin (w_o t + \delta) \times \cos (w_o t - \phi) \quad \text{und}$$
$$\sin (w_c t + \delta) \times \sin w_o t)$$

Am Ausgang der Tiefpaßfilter 14 und 15 treten folgende

J. Reed-3

Signale auf:

$$A \times \sin\left[(w_c - w_o) \times t + \delta + \phi\right] \quad \text{und}$$
$$A \times \cos\left[(w_c - w_o) \times t + \delta\right]$$

In ähnlicher Weise abgeleitet treten an den Ausgängen e und f der Tiefpaßfilter 20 und 21 folgende Signale auf:

$$D \times \cos\left[(w_a - w_o) \times t + \beta\right]$$
$$D \times \sin\left[(w_a - w_o) \times t + \beta + \phi\right]$$

Mit den Voraussetzungen $w_c - w_o = w_a - w_o = 0$ entstehen an den Ausgängen k und h der Mischschaltungen 18 und 19 folgende Eingangssignale für den Verstärker 30:

$$A \times D \times \sin(\delta + \phi) \times \cos\beta$$
$$A \times D \times \cos\delta \times \sin(\beta + \phi)$$

Und durch Erweiterung dieser Ausdrücke:

$$A \times D \times \sin(\delta+\phi) \times \cos\beta = A \times D(\sin\delta \times \cos\phi + \cos\delta \times \sin\phi) \times \cos\beta$$
$$A \times D \times \cos\delta \times \sin(\beta+\phi) = A \times D(\sin\beta \times \cos\phi + \cos\beta \times \sin\phi) \times \cos\delta$$

Durch Subtraktion dieser beiden Signale ergibt sich am Ausgang jedes Operationsverstärkers 30:

$$A \times D \times \cos\phi \times \sin(\delta - \beta) \to 0$$

Zur Erfüllung dieser Gleichung gilt $\beta = \delta$. Die einzige Auswirkung des unvollkommenen Phasensplittings ist eine Verringerung der Empfindlichkeit der Mischerschaltung infolge $\cos\phi$. Für kleine Phasenfehler ist diese Störung vernachlässigbar ($\cos\phi \to 1$ für $\phi \to 0$).

Die Schaltungsanordnung kompensiert somit Phasenungenauigkeiten.

In ähnlicher Weise kann gezeigt werden, daß die Verzerrungsprodukte, die durch versehentliche Verzerrungsfehler zwischen den Kanälen verursacht werden, nicht größer sind als in ähnlichen Empfangsgeräten, die die dargestellten

J. Reed-3

Anordnungen nicht verwenden, nicht größer sind. Tatsächlich verursachen die meisten Verstärkungsunterschiede nur halb so viel Verzerrungen wie in anderen vergleichbaren Systemen. Durch Anwendung eines zweiten Schaltsystemes, wie es hier für die Verstärkungsregelung vorgesehen ist, können Ungleichheiten in der Kanalverstärkung ausgeglichen werden.

In der dargestellten Demodulatoranordnung oder Empfangsschaltung können schmalbandige oder steile Filter verwendet werden, ohne daß Schleifeninstabilitäten auftreten. Die Verwendung eines spannungsgesteuerten Oszillators ermöglicht für die Mischschaltungen 18 und 19 einen zuverlässigen Betrieb über weite Bereiche, da sichergestellt ist, daß die Frequenz des spannungsgesteuerten Oszillators sicher geregelt ist.

Fehler, sowohl im Phasengenerator als auch in der Quadraturschaltung des lokalen Oszillators als auch Fehler des Nutzsignales werden ebenso kompensiert. Eine Anordnung mit einer hohen Schaltrate ermöglicht ein Regelsignal für die Verstärkungsregelung zu erzeugen, das bezüglich der Amplitude und Wiedergabetreue für alle Kanäle und gebräuchlichen Verstärker geeignet ist. Die Anordnung ermöglicht ausserdem eine Demodulation innerhalb oder außerhalb der Phase.

Nachfolgend wird ein weiteres bevorzugtes Ausführungsbeispiel einer Demodulatoranordnung zur Demodulation frequenzmodulierter Nutzsignale in einer einfacheren Ausbildung beschrieben. Diese Demodulatoranordnung enthält ebenfalls einen lokalen Oszillator zur Erzeugung eines ersten und eines zweiten Ausgangssignals, die zueinander in Phasenquadratur stehen und eine Frequenz aufweisen, die gleich

J. Reed-3

der Trägerfrequenz der empfangenen Trägerfrequenzwelle ist. Außerdem enthält die Anordnung eine erste und eine zweite Mischerschaltung, in der das frequenzmodulierte Eingangssignal mit den beiden Ausgangssignalen des lokalen Oszillators gemischt wird. An die Ausgänge der beiden Mischeranordnungen sind Tiefpaßfilter angeschlossen, die die gefilterten Ausgangssignale der beiden Mischeranordnungen als gefilterte Signale jeweils an einen ersten Eingang einer dritten und einer vierten Mischanordnung anliegen. Und zwar ist der eine Mischeingang der dritten Mischanordnung über das eine Tiefpaßfilter mit dem Ausgang der ersten Mischanordnung verbunden und der erste Mischeingang der vierten Filteranordnung über das andere Tiefpaßfilter mit dem Ausgang der zweiten Mischanordnung verbunden. Außerdem enthält die Anordnung einen spannungsgesteuerten Oszillator, dessen Ausgang angepaßt an den anderen Eingang der dritten und der vierten Mischanordnung angeschlossen ist. Der spannungsgesteuerte Oszillator enthält einen Regeleingang zur Regelung von dessen Frequenz. An den Ausgang der dritten und der vierten Mischanordnung ist je ein Eingang einer Summenschaltung angeschlossen, die an ihrem Ausgang ein Differenzsignal erzeugt. Zwischen diesen Ausgang und den Regeleingang des spannungsgesteuerten Oszillators ist eine Regelschaltung angeordnet, über die die Demodulatoranordnung so geregelt wird, daß am Ausgang der Summenschaltung ein Ausgangssignal entsteht, das das von der Trägerfrequenz demodulierte Signal darstellt.

J. Reed-3

Patentansprüche

1. Demodulatoranordnung zur Demodulation von in einer Frequenzmodulation auf einer Trägerfrequenzwelle enthaltenen Nutzsignalen
mit einem lokalen Oszillator, dessen Frequenz auf die Frequenz der Trägerwelle abgestimmt ist und der in einer Quadraturanordnung aus der Oszillatorschwingung zwei in Phasenquadratur zueinander liegende Ausgangssignale erzeugt
und mit einer ersten und einer zweiten Mischerschaltung, an deren ersten Mischeingang die ankommende Trägerfrequenzwelle angelegt ist und deren zweite Mischeingänge jeweils ein Signalausgang des lokalen Oszillators angeschlossen ist,
ferner mit je einem Tiefpaßfilter am Ausgang jeder der beiden Mischerschaltungen, derart, daß die erste Mischerschaltung mit dem ersten Tiefpaßfilter einen ersten Kanal und die zweite Mischerschaltung mit dem zweiten Tiefpaßfilter einen zweiten Demodulatorkanal bilden,
außerdem mit je einer Multiplikationsschaltung in jedem Demodulatorkanal, deren Ausgangssignale an die Eingänge einer Differenzschaltung gelangen,
d a d u r c h   g e k e n n z e i c h n e t,
daß die beiden Multiplikationsschaltungen eine dritte

ZT/P2-Lr/fö
18.01.1983

J. Reed-3

Mischerschaltung (18) und eine vierte Mischerschaltung
(19) sind, deren erster Mischereingang mit dem Ausgang
(a) des im Demodulatorkanal befindlichen Tiefpaßfilters
(14) verbunden ist und deren zweiter Mischeingang mit
dem Ausgang eines spannungsgesteuerten Oszillators (24)
verbunden ist,
daß zwischen dem Ausgang (g) der Differenzschaltung (30)
und einem Regeleingang zur Frequenzeinstellung des spannungsgesteuerten Oszillators (24) eine elektrische Kopplung (33) besteht
und daß der entkoppelte Ausgang der Differenzschaltung
(30) der Demodulatorausgang (Kondensator 32) ist.

2. Demodulatoranordnung nach Anspruch 1, dadurch gekennzeichnet, daß zwischen dem Ausgang des spannungsgesteuerten Oszillators(24)und die zweiten Mischeingänge des
zweiten Paares von Mischerschaltungen (18, 19) ein
drittes Paar von Mischerschaltungen (22, 23) geschaltet
ist, von dessen Mischerschaltungen (22, 23) der erste
Mischeingang mit dem Ausgang des spannungsgesteuerten
Oszillators(24)verbunden ist, der zweite Mischeingang
mit dem Signalausgang des lokalen Oszillators(44),an
den der zweite Mischeingang der im anderen Demodulatorkanal liegenden Mischerschaltung des ersten Mischerschaltungspaares (12, 13) angeschlossen ist, und der
Mischerausgang über ein Tiefpaßfilter (20, 21) mit dem
zweiten Mischeingang des im gleichen Demodulatorkanal
liegenden zweiten Mischerschaltungspaares (18, 19) verbunden ist.

3. Demodulatoranordnung nach Anspruch 2, dadurch gekennzeichnet, daß der spannungsgesteuerte Oszillator (24)
auf die gleiche Frequenz wie der lokale Oszillator (44)
eingestellt ist.

J. Reed-3

4. Demodulatoranordnung nach einem der vorhergehenden Ansprüche, dadurch gekennzeichnet, daß der Durchlaßbereich der Tiefpaßfilter (12, 13, 20, 21) wenigstens die Bandbreite des einen Seitenbandes für das auf die Trägerwelle modulierte Nutzsignal ist.

5. Demodulatoranordnung nach einem der vorhergehenden Ansprüche, dadurch gekennzeichnet, daß das erste Ausgangssignal des lokalen Oszillators (44) die Form $\cos w_o t$ und das dazu phasenquadrierte zweite Ausgangssignal die Form $\sin w_o t$ aufweist, wobei $w_o$ das $2\Pi$-fache der Frequenz des lokalen Oszillators ist.

6. Demodulatoranordnung nach einem der vorhergehenden Ansprüche, dadurch gekennzeichnet, daß der lokale Oszillator (44) abstimmbar ist, daß ferner eine Schaltungsanordnung vorgesehen ist, die eine der Frequenz, auf die der lokale Oszillator abgestimmt ist, entsprechende Abstimmspannung erzeugt, und daß diese Abstimmspannung an einen Abstimmeingang (25) des spannungsgesteuerten Oszillators (24) angeschlossen ist.

7. Demodulatoranordnung nach einem der vorhergehenden Ansprüche, dadurch gekennzeichnet, daß die Differenzschaltung (30) ein Differenzverstärker ist.

8. Demodulatoranordnung nach einem der vorhergehenden Ansprüche, dadurch gekennzeichnet, daß in jedem Demodulatorkanal wenigstens ein in seiner Verstärkung regelbarer Verstärker vor einem Mischeingang der beiden Mischerschaltungen (18, 19) des zweiten Mischerschaltungspaares angeordnet ist.

0084876

J. Reed-3

9. Demodulatoranordnung nach Anspruch 8, dadurch gekennzeichnet,
daß zwischen die zweiten Mischeingänge der Mischerschaltungen (18, 19) des zweiten Mischerschaltungspaares und die Ausgänge der Mischerschaltungen (22, 23) des dritten Mischerschaltungspaares ein erster zweipoliger elektronischer Umschalter (40) derart angeordnet ist, daß er die Ausgänge der Mischerschaltungen des dritten Mischerschaltungspaares wechselpolig an die zweiten Mischeingänge des zweiten Mischerschaltungspaares anschließt, daß an die Ausgänge (h, k) der Mischerschaltungen (18, 19) des zweiten Mischerschaltungspaares ein zweiter zweipoliger elektronischer Umschalter (41) angeschlossen ist, der die Ausgänge (h, k) der Mischerschaltungen (18, 19) wechselweise an die Eingänge der Differenzschaltung (30) und bei einer Verpolung der Demodulatorkanäle durch den Umschalter (40) an die Summeneingänge eines zweiten Verstärkers (45) zur Erzeugung eines Regelsignals (AGC) schaltet,
daß die Umschalter (40, 41) von einer Schaltsignalquelle (43) gesteuert werden, deren Schaltsignal eine Schaltfrequenz aufweist, die wesentlich größer ist als die höchste empfangbare Trägerwellenfrequenz,
und daß der Ausgang des Regelspannungsverstärkers (45) mit den Regeleingängen zur Regelung der Verstärkung der in den Demodulatorkanälen angeordneten Verstärkern (16, 17) verbunden ist.

FIG.1

FIG. 2